# EUROPÄISCHE PATENTANMELDUNG

(11) **EP 1 726 994 A2**
(43) Veröffentlichungstag der Anmeldung: **29.11.2006**
(21) Anmeldenummer: 06114425.9
(22) Anmeldetag: 23.05.2006
(51) Int. Cl.: G03F 7/20

(54) **Lichtintegrator für ein Beleuchtungssystem, insbesondere für eine mikrolithographische Projektionsbelichtungsanlage**

(30) Priorität: 25.05.2005 US 684602 P
(71) Anmelder: Carl Zeiss SMT AG, 73447 Oberkochen (DE)
(72) Erfinder: Fiolka, Damian, 73447, Oberkochen (DE); Zaczek, Christoph, 73540, Heubach (DE); Totzeck, Michael, 73525, Schwäbisch Gmünd (DE); Gischa, Roland, 89075, Ulm (DE)
(74) Vertreter: Frank, Hartmut

(57) **Zusammenfassung**

Die Erfindung betrifft einen Lichtintegrator für ein Beleuchtungssystem, insbesondere für eine mikrolithographische Projektionsbelichtungsanlage, wobei der Lichtintegrator wenigstens einen Integratorstab aus einem für Licht einer Lichtquelle transparenten Material aufweist, welcher eine Lichteintrittsfläche, eine Lichtaustrittsfläche und Mantelflächen aufweist. Um eine verbesserte Polarisationserhaltung zu ermöglichen, ist wenigstens eine der Mantelflächen (104-107, 204-207) zumindest bereichsweise mit einer Belegung präpariert, welche derart ausgestaltet ist, dass sie für in die Lichteintrittsfläche (102, 202) eintretendes, linear polarisiertes Licht einer bei einem Integratorstab ohne diese Belegung erfolgenden Änderung des Polarisationszustandes zwischen dem Lichteintritt in die Lichteintrittsfläche (102, 202) und dem Lichtaustritt aus der Lichtaustrittsfläche (103, 203) entgegenwirkt.

## Beschreibung

Die Erfindung betrifft einen Lichtintegrator für ein Beleuchtungssystem, insbesondere ein Beleuchtungssystem einer mikrolithographischen Projektionsbelichtungsanlage.

Mikrolithographie wird zur Herstellung mikrostrukturierter Bauelemente, wie beispielsweise integrierter Schaltkreise oder LCD's, angewendet. Der Mikrolithographieprozess wird in einer sogenannten Projektionsbelichtungsanlage durchgeführt, welche ein Beleuchtungssystem und ein Projektionsobjektiv aufweist. Das Bild einer mittels des Beleuchtungssystems beleuchteten Maske (= Retikel) wird mittels des Projektionsobjektivs auf ein mit einer lichtempfindlichen Schicht (z.B. Photoresist) beschichtetes und in der Bildebene des Projektionsobjektivs angeordnetes Substrat (z.B. einen Siliziumwafer) projiziert, um die Maskenstruktur auf die lichtempfindliche Beschichtung des Substrats zu übertragen.

Um die Maske möglichst gleichmäßig und homogen zu beleuchten, ist es bekannt, in der Beleuchtungseinrichtung Lichtmischeinrichtungen z.B. in Form von Wabenkondensatoren oder Integratorstäben einzusetzen. Ein Integratorstab (auch als Stabhomogenisierer bezeichnet) besteht aus einem für das Beleuchtungslicht transparenten Material, je nach Arbeitswellenlänge beispielsweise aus synthetischem Quarzglas oder Kalziumfluorid. Bei Durchstrahlung des Integratorstabs mit dem Beleuchtungslicht wird infolge von an den Mantelflächen auftretenden Totalreflexionen eine weitgehend homogene Lichtdurchmischung erreicht.

Bei Verwendung von Stabintegratoren als Lichtmischer in einer Projektionsbelichtungsanlage kann jedoch infolge der an den Mantelflächen stattfindenden Totalreflexionen und der damit verbundenen Ansammlung von Phasenverschiebungen zwischen zueinander senkrechten Polarisationszuständen, aber auch durch intrinsische oder spannungsinduzierte Doppelbrechung im Material des Integratorstabs (z.B. CaF₂), das Problem einer unerwünschten Veränderung des Polarisationszustandes des durch den Stabintegrator hindurchtretenden Lichts auftreten. Sofern ein ursprünglich definierter linearer Polarisationszustand dann z.B. mittels eines dem Stabintegrator nachgeordneten Polarisationsfilters wiederhergestellt wird, führt dies zu einem unerwünschten Intensitätsverlust.

Aus WO 03/077011 A1 ist es zur Reduzierung/Kompensation dieser unerwünschten Polarisationszustandsveränderung durch einen Lichtintegrator bekannt, ein optisches System in zwei Teilsysteme zu zerlegen und dazwischen einen Retarder zu platzieren, der als Lambda/2-Platte wirkt. So werden zwei zueinander senkrechte Polarisationszustände zwischen den Teilsystemen vertauscht, und die Aufsummierung der Phasensprünge im zweiten Teilsystem hebt gerade diejenige im ersten Teilsystem auf. Insbesondere können die beiden Teilsysteme zwei Stabhälften eines Stabintegrators sein. Der Retarder kann insbesondere in Form einer Lambda/2-Platte, zweier mit ihrer schnellen Achse gegeneinander um 45° gedrehter Lambda/2-Platten oder auch in Form entsprechender Beschichtungen an Linsen des ersten und zweiten Teilsystems ausgestaltet sein.

Aus DE 103 11 809 A1 ist es bekannt, zur Polarisationsoptimierung eines Beleuchtungssystems mittels einer Manipulationseinrichtung im Stabintegrator unter Ausnutzung von spannungsinduzierter Doppelbrechung ein nicht-symmetrisches Brechzahlprofil so zu erzeugen, dass im Vergleich zu einem Stabintegrator mit symmetrischem Brechzahlprofil eine wesentliche Verminderung der durch den Stabintegrator bewirkten Veränderung des Polarisationsgrades erreicht wird, so dass der Stabintegrator im Idealfall und je nach eingestelltem Beleuchtungssetting polariationserhaltend wirkt.

Des weiteren sind auch diverse Designs zur Optimierung der Polarisationserhaltung oder auch zur gezielten Polarisationsbeeinflussung im Lichtweg von Beleuchtungssystemen und/oder Projektionsobjektiven einer Projektionsbelichtungsanlage bekannt, von denen nachfolgend einige beispielhaft angegeben werden.

Aus DE 102 29 614 A1 ist es zur Kompensation von Reflektivitäts- und Phasenunterschieden infolge der Reflexionen an zwei in einem katadioptrischen Reduktionsobjektiv vorhandenen Umlenkspiegeln bekannt, im Lichtweg zwischen diesen Umlenkspiegeln eine Polarisationsdreheinrichtung (z.B. Lambda/2-Platte) anzuordnen, so dass sich im Ergebnis ein Ausgleich und eine Kompensationswirkung sowohl hinsichtlich der durch Spiegelreflexionen aufgebauten Amplituden- als auch Phasendifferenzen ergibt.

Weiter ist es aus DE 102 40 598 A1 und WO 2004/025370 A1 für eine zu DE 102 29 614 A1 analoge Anordnung ohne Polarisationsdreheinrichtung zwischen den Umlenkspiegeln bekannt, die auf den Umlenkspiegeln vorgesehenen Reflexbeschichtungen so auszugestalten, dass in einem relevanten Inzidenzwinkelbereich bei dem einen Umlenkspiegel das Verhältnis zwischen dem Reflexionsgrad für s-polarisiertes Licht und dem Reflexionsgrad für p-polarisiertes Licht größer als Eins und bei dem anderen Spiegel kleiner als Eins ist. Die Reflexbeschichtungen umfassen hierbei jeweils eine Metallschicht und eine darauf angeordnete dielektrische Einfach- oder Mehrfachschicht, deren Materialien und Schichtdicken zur Realisierung der angestrebten Reflexionsgradcharakteristika entsprechend angepasst sind.

Aufgabe der vorliegenden Erfindung ist es, einen Lichtintegrator für ein Beleuchtungssystem, insbesondere für eine mikrolithographische Projektionsbelichtungsanlage bereitzustellen, welcher eine verbesserte Polarisationserhaltung ermöglicht.

Diese Aufgabe wird durch die Merkmale des unabhängigen Patentanspruchs 1 gelöst.

Erfindungsgemäß weist ein Lichtintegrator für ein Beleuchtungssystem, insbesondere für eine mikrolithographische Projektionsbelichtungsanlage, zumindest einen Integratorstab aus einem für Licht einer Lichtquelle transparenten Material auf, welcher eine Lichteintrittsfläche, eine Lichtaustrittsfläche und Mantelflächen aufweist, wobei wenigstens eine der Mantelflächen zumindest bereichsweise mit einer Belegung präpariert ist, welche derart ausgestaltet ist, dass sie für in die Lichteintrittsfläche eintretendes, linear polarisiertes Licht einer bei einem Integratorstab ohne diese Belegung erfolgenden Änderung des Polarisationszustandes zwischen dem Lichteintritt in die Lichteintrittsfläche und dem Lichtaustritt aus der Lichtaustrittsfläche entgegenwirkt.

Im Rahmen der vorliegenden Anmeldung ist unter einem Lichtintegrator entsprechend der üblichen Terminologie eine Lichtmischeinrichtung zur Homogenisierung des sich in dem Beleuchtungssystem ausbreitenden (von der Laserlichtquelle erzeugten) Lichtes zu verstehen.

Die Erfindung geht von der Erkenntnis aus, dass bei Durchtritt eines Lichtstrahls durch einen herkömmlichen Lichtintegrator bekanntermaßen bei jeder Totalreflexion an einer Mantelfläche eine Phasenverschiebung zwischen der senkrecht zur Einfallsebene orientierten Komponente Eₛ und der parallel zur Einfallsebene orientierten Komponente Eₚ stattfindet, die vom Einfallswinkel auf die Grenzfläche abhängt. Durch die erfindungsgemäße Belegung wird nun einer Änderung des Polarisationszustandes infolge dieser Phasensprünge gezielt entgegengewirkt, so dass im Ergebnis eine verbesserte Polarisationserhaltung ermöglicht wird. Vorzugsweise handelt es sich bei der erfindungsgemäßen Belegung um eine phasenschiebende Belegung, d.h. eine Belegung, die gezielt eine Phasenverschiebung zwischen zueinander senkrechten Polarisationszuständen (s- und p-Polarisation) bewirkt. Allgemein wird dabei im Sinne der vorliegenden Anmeldung unter einer Belegung sowohl eine Schicht oder Schichtstruktur als auch z.B. eine Lambda/4-Platte verstanden.

Gemäß einer bevorzugten Ausgestaltung ist die Belegung derart ausgestaltet, dass für in die Lichteintrittsfläche eintretendes, linear polarisiertes Licht der Polarisationszustand nach Austritt aus der Lichtaustrittsfläche im Wesentlichen erhalten bleibt. Unter der Formulierung "im Wesentlichen erhalten" ist dabei im Sinne der vorliegenden Anmeldung zu verstehen, dass bei dem Lichtintegrator das Verhältnis von dem linearen Polarisationsgrad am Stabaustritt zu dem linearen Polarisationsgrad am Stabeintritt wenigstens 0.8, vorzugsweise wenigstens 0.9 und noch bevorzugter im Wesentlichen 1 beträgt. Hierbei ist der lineare Polarisationsgrad definiert als das Verhältnis der Intensität des linear polarisierten Lichtanteils zur Intensität des Gesamtlichts. Dementsprechend hat vollständig linear polarisiertes Licht den linearen Polarisationsgrad Eins, vollständig unpolarisiertes Licht den linearen Polarisationsgrad Null und partiell polarisiertes Licht einen Polarisationsgrad zwischen den Werten Null und Eins.

Gemäß einer bevorzugten Ausführungsform ist die Belegung in Form einer dielektrischen Schichtstruktur ausgebildet.

Die erfindungsgemäße Belegung auf der oder den Mantelflächen bewirkt gemäß einer bevorzugten Ausführungsform gezielt bei jeder dieser Totalreflexionen zwischen der senkrecht zur Einfallsebene orientierten Komponente Eₛ und der parallel zur Einfallsebene orientierten Komponente Eₚ einen Phasensprung von vorzugsweise von etwa 180°.

Nimmt man beispielsweise an, dass vor einer ersten Totalreflexion an einer erfindungsgemäß belegten Mantelfläche die parallel zur Einfallsebene orientierte Komponente Eₚ der senkrecht zur Einfallsebene orientierten Komponente Eₛ in der Phase vorauseilt, so eilt die gleiche (vor der Totalreflexion vorausgeeilte) Komponente Eₚ nach dem bei dieser ersten Totalreflexion stattfindenden Phasensprung von etwa 180° der anderen Komponente Eₛ hinterher, und zwar bei einem Phasensprung von exakt 180° um die gleiche Phasendifferenz, um die sie vor der Totalreflexion vorausgeeilt ist. Bei der zweiten Totalreflexion an einer erfindungsgemäß belegten Mantelfläche findet erneut ein Phasensprung von etwa 180° statt, so dass die vor der zweiten Totalreflexion hinterhergeeilte Komponente Ep nach der zweiten Totalreflexion wieder der anderen Komponente Eₛ vorauseilt etc. Bei idealen Phasensprüngen von 180° an den erfindungsgemäß belegten Mantelflächen wird somit die bei einer Totalreflexion aufgesammelte Phasendifferenz Δ(φₚ-φₛ) durch die bei einer nächsten Totalreflexion aufgesammelte Phasendifferenz Δ(φₛ-φₚ) gerade kompensiert. Betrachtet man z.B. Licht, welches bei Eintritt in die Lichteintrittsfläche des Stabintegrators in zu einer der Mantelflächen paralleler x-Richtung linear polarisiert ist, so ist dieses Licht, wenn es nach einer beliebigen Anzahl von Totalreflexionen den Stabintegrator aus der Lichtaustrittsfläche verlässt, beim Austritt aus der Lichtaustrittsfläche des Stabintegrators immer noch in x-Richtung linear polarisiert, so dass der Polarisationszustand erhalten bleibt. In gewissem Rahmen ist durch die erfindungsgemäße Belegung der Mantelflächen auch eine Kompensationswirkung hinsichtlich Phasenaufspaltungen denkbar, die durch intrinsische bzw. spannungsinduzierte Doppelbrechung im Material des Integratorstabs, d.h. zwischen aufeinanderfolgenden Totalreflexionen, verursacht werden.

Für den Fachmann ist ersichtlich, dass eine verbesserte Erhaltung des Polarisationszustandes nicht nur bei einem durch die Belegung bewirkten "idealen" Phasensprung von 180° auftritt, sondern auch bei einem durch das Schichtsystem bewirkten Phasensprung, der vom 180° abweicht, jedoch noch in einer nicht zu großen Umgebung des 180°-Wertes liegt. Gemäß einer bevorzugten Ausführung bewirkt die Schichtstruktur für einen an der jeweiligen Mantelfläche im Bereich der Schichtstruktur reflektierten Lichtstrahl in einem vorgegebenen Einfallswinkelbereich einen Phasensprung zwischen zwei zueinander senkrechten Polarisationszuständen im Bereich von 130° bis 230°, bevorzugt im Bereich von 155° bis 205°, und idealerweise von etwa 180°. Dieser Einfallswinkelbereich kann insbesondere im Bereich von etwa 60° bis 85° liegen.

Gemäß einem anderen Aspekt ist die dielektrische Schichtstruktur so ausgebildet, dass für einen im Bereich der Schichtstruktur reflektierten Lichtstrahl in einem vorgegebenen Einfallswinkelbereich ein Phasensprung zwischen zwei zueinander senkrechten Polarisationszuständen geringer als 30°, bevorzugt geringer als 20° und noch bevorzugter geringer als 10° ist. Dieser Einfallswinkelbereich kann ebenfalls insbesondere im Bereich von etwa 60° bis 85° liegen. In dieser Ausführungsform wird somit anstelle eines gezielten Phasensprungs von etwa 180° vielmehr der Ansatz verfolgt, den bei einer Totalreflexion im Bereich der dielektrischen Schichtstruktur erfolgenden Phasensprung zwischen zwei zueinander senkrechten Polarisationszuständen zu minimieren.

Die dielektrische Schichtstruktur weist vorzugsweise wenigstens eine erste Schicht aus einem ersten dielektrischen Material und wenigstens eine zweite Schicht aus einem zweiten dielektrischen Material auf. Vorzugsweise weist dabei das erste dielektrische Material eine erste Brechzahl n auf, welche größer als die Brechzahl des Materials des Integratorstabs ist, und das zweite dielektrische Material weist eine zweite Brechzahl n auf, welche kleiner als die Brechzahl des Materials des Integratorstabs ist. Das erste dielektrische Material der dielektrischen Schichtstruktur ist vorzugsweise aus der Gruppe ausgewählt, welche aus Lanthanfluorid (LaF₃), Neodymfluorid (NdF₃), Aluminiumoxid (Al₂O₃), Gadoliniumfluorid (GdF₃), Dysprosiumfluorid (DyF₃), Erbiumfluorid (ErF₃) und Zirkoniumfluorid (ZrF₄) besteht. Das zweite dielektrische Material ist vorzugsweise aus der Gruppe ausgewählt, welche aus Chiolith, Magnesiumfluorid (MgF₂), Lithiumfluorid (LiF), Natriumfluorid (NaF), Siliziumdioxid (SiO₂), Kryolith und Aluminiumfluorid (AlF₃) besteht.

Gemäß einer anderen Ausführungsform der Erfindung ist die Belegung als eine auf der jeweiligen Mantelfläche angeordnete Lambda/4-Platte ausgebildet, die aus einem beliebigen geeigneten doppelbrechenden Material, beispielsweise für eine Arbeitswellenlänge von 193nm aus Magnesiumfluorid (MgF₂) oder Quarz (SiO₂) hergestellt sein kann. In dieser Ausführungsform hat die auf der Mantelfläche befindliche Lambda/4-Platte zur Folge, dass zwischen zwei aufeinanderfolgenden Totalreflexionen an Mantelflächen, die mit der Lambda/4-Platte belegt sind, ein durch den Integratorstab hindurchlaufender Lichtstrahl zweimal die Dicke der Lambda/4-Platte durchläuft, insgesamt also zwischen zwei aufeinanderfolgenden Totalreflexionen gleichsam eine Lambda/2-Platte durchquert.

Gemäß einer bevorzugten Ausführungsform ist der Integratorstab aus einem Fluoridkristall, vorzugsweise Kalziumfluorid (CaF₂), hergestellt. Hierbei sind vorzugsweise sämtliche Mantelflächen des Integratorstabs senkrecht zur <100>-Kristallrichtung angeordnet (was infolge der vierzähligen Symmetrie dieser Hauptkristallrichtung möglich ist).

Gemäß einer weiteren bevorzugten Ausführungsform sind zusätzlich zu dem ersten Integratorstab ein zweiter Integratorstab sowie ein Lambda/2-Retarder derart vorgesehen, dass durch den Lichtintegrator hindurchtretendes Licht nacheinander den ersten Integratorstab, den Lambda/2-Retarder und den zweiten Integratorstab durchquert. Der erste Integratorstab und der zweite Integratorstab weisen vorzugsweise im Wesentlichen identische Abmessungen auf. Insbesondere unterscheiden sich vorzugsweise die Querschnittsflächen der Integratorstäbe sowohl in longitudinaler als auch in transversaler Richtung zwischen den Integratorstäben jeweils um weniger als 30% bezogen auf den jeweiligen Maximalwert.

Gemäß einer bevorzugten Ausgestaltung ist die Belegung nur an dem ersten Integratorstab vorgesehen.

Gemäß einer bevorzugten Ausgestaltung ist ferner die Belegung nur an zwei einander gegenüberliegend angeordneten Mantelflächen des betreffenden Integratorstabs vorgesehen.

Gemäß einer bevorzugten Ausgestaltung ist der jeweilige Integratorstab mit einem senkrecht zur Lichtausbreitungsrichtung rechteckigen Querschnitt mit zwei breiteren und zwei schmaleren Mantelflächen ausgebildet, wobei nur die schmaleren Mantelflächen vollständig oder teilweise mit der Belegung präpariert sind.

Gemäß einer weiteren Ausführungsform kann die Schichtstruktur zumindest an zwei einander gegenüberliegend angeordneten Mantelflächen des Integratorstabs auch nur in entlang der Längsrichtung in im Wesentlichen gleichen Abständen angeordneten, vorzugsweise streifenförmigen Bereichen ausgebildet sein.

Der erfindungsgemäße Lichtintegrator ist bevorzugt für eine Arbeitswellenlänge von 248 nm, weiter bevorzugt 193 nm, noch bevorzugter 157 nm ausgelegt.

Die Erfindung betrifft auch eine mikrolithographische Projektionsbelichtungsanlage, ein Verfahren zur mikrolithographischen Herstellung mikrostrukturierter Bauelemente und ein mikrostrukturiertes Bauelement.

Gemäß einer bevorzugten Ausführungsform weist das Beleuchtungssystem ein Elliptizitätsfilter auf, welches einen durch die Belegung der Mantelflächen eingeführten elliptischen Anteil in der sich nach Stabaustritt ergebenden Intensitätsverteilung reduziert.

Gemäß einer bevorzugten Ausführungsform weist das Beleuchtungssystem eine Blende auf, welche einen äußeren Ring sowie eine Mehrzahl an von diesem äußeren Ring radial nach innen ragenden, lichtblockierenden Vorsprüngen aufweist, welche derart angeordnet sind, dass durch selektives Herausfiltern von Bereichen des Lichtbündelquerschnitts der mittlere Polarisationserhaltungsgrad gegenüber einem Beleuchtungssystem ohne die Blende verbessert wird. Der Einsatz einer solchen Blende ist in einem Beleuchtungssystem zur Verbesserung des mittleren Polarisationserhaltungsgrades auch unabhängig von der erfindungsgemäßen Belegung von Mantelflächen wenigstens eines Integratorstabes vorteilhaft und kann demnach auch unabhängig von einer solchen Belegung erfolgen.

Weitere Ausgestaltungen der Erfindung sind der Beschreibung sowie den Unteransprüchen zu entnehmen.

Die Erfindung wird nachstehend anhand von in den beigefügten Abbildungen dargestellten Ausführungsbeispielen näher erläutert.

Es zeigen:
- Figur 1: eine schematische Seitenansicht eines Lichtintegrators gemäß einer Ausführungsform der Erfindung;
- Figur 2: eine schematische Seitenansicht eines Lichtintegrators gemäß einer weiteren Ausführungsform der Erfindung;
- Figur 3: eine schematische Seitenansicht eines Lichtintegrators gemäß einer weiteren Ausführungsform der Erfindung;
- Figur 4: a)-d) schematische perspektivische Ansichten eines Lichtintegrators gemäß weiterer Ausführungsformen der Erfindung;
- Figur 4e: eine schematische Darstellung eines in einer Beleuchtungseinrichtung mit dem erfindungsgemäßen Lichtintegrator gemäß einer bevorzugten Ausführungsform vorgesehenen Elliptizitätsfilters;
- Figur 5: eine mittels Simulation berechnete Abhängigkeit des gemittelten linearen Polarisationsgrads P von der auf die maximale Systemapertur normierten numerischen Apertur am Stabeintritt für einen beispielhaften Lichtintegrator gemäß der Erfindung;
- Fig. 6: eine schematische Darstellung der Phasenaufspaltung zwischen zueinander senkrechten Polarisationszuständen in Abhängigkeit vom Einfallswinkel für einen Lichtintegrator mit Mantelflächen ohne erfindungsgemäße Belegung;
- Figur 7: eine berechnete Abhängigkeit der Phasenaufspaltung (Figur 7a) und der Reflexion (Figur 7b) vom Einfallswinkel für verschiedene Ausführungsbeispiele der Belegung eines erfindungsgemäßen Lichtintegrators mit einer dielektrischen Schichtstruktur;
- Figur 8: a)-b) eine berechnete Abhängigkeit der Phasenaufspaltung (Figur 8a) bzw. des Reflexionsgrades (Figur 8b) vom Einfallswinkel für einen Lichtintegrator ohne bzw. mit erfindungsgemäßer Schichtstruktur gemäß weiteren Ausführungsbeispielen der Erfindung;
- Figur 9: eine schematische Darstellung des Aufbaus eines Beleuchtungssystems einer mikrolithographischen Projektionsbelichtungsanlage mit einem Lichtintegrator gemäß der vorliegenden Erfindung;
- Figur 10: eine schematische Darstellung einer in einem erfindungsgemäßen Beleuchtungssystem in einer bevorzugten Ausführungsform eingesetzten Blende;
- Figur 11: eine schematische Darstellung einer in einem erfindungsgemäßen Beleuchtungssystem eingesetzten Blende gemäß einer weiteren Ausführungsform; und
- Figur 12: eine schematische Darstellung des Aufbaus einer mikrolithographischen Projektionsbelichtungsanlage mit einem Beleuchtungssystem gemäß der vorliegenden Erfindung;

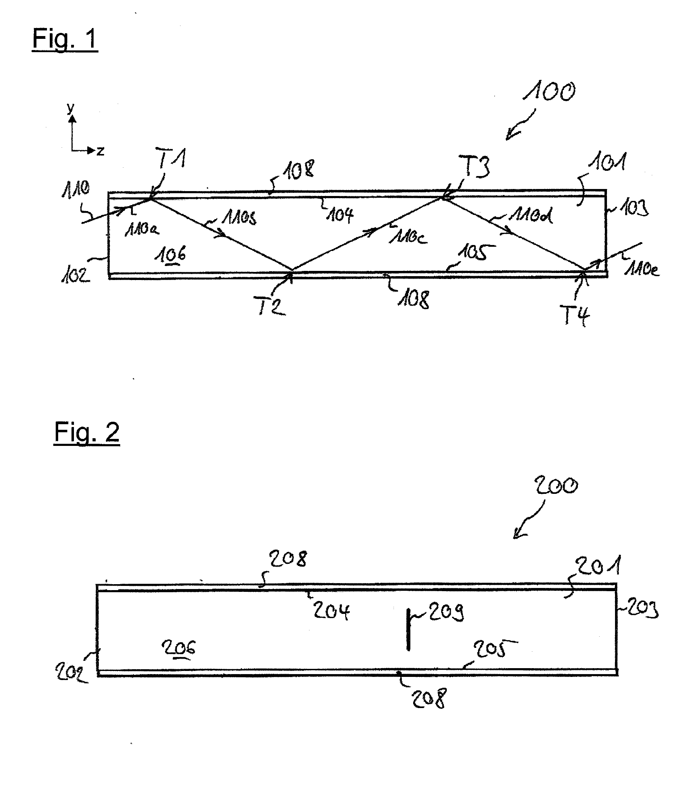

Gemäß Fig. 1 weist ein schematisch in Seitenansicht dargestellter Lichtintegrator 100 einen Integratorstab 101 von beispielsweise quaderförmiger Geometrie mit einer Lichteintrittsfläche 102, einer Lichtaustrittsfläche 103 sowie vier Mantelflächen 104-107 auf, von denen in Fig. 1 nur die obere Mantelfläche 104, die untere Mantelfläche 105 und die vordere Mantelfläche 106 erkennbar sind. Der Integratorstab 101 ist aus einem für die jeweilige Arbeitswellenlänge transparenten Material hergestellt und kann quer zur Lichtausbreitungsrichtung bzw. der optischen Achse einen beliebigen geeigneten Querschnitt, vorzugsweise einen rechteckigen oder auch quadratischen Querschnitt aufweisen. Im DUV-Bereich (DUV = "deep ultraviolet = tiefes Ultraviolett) mit Wellenlängen von z.B. 193 nm und 157 nm sind insbesondere Fluoridkristallmaterialien wie z.B. Kalziumfluorid (CaF₂), Bariumfluorid (BaF₂), Magnesiumfluorid (MgF₂) oder Lithiumfluorid (LiF₂) geeignet.

Der Lichtintegrator 100 weist ferner ein dielektrisches Schichtsystem 108 auf, welches gemäß dem Ausführungsbeispiel von Fig. 1 auf sämtlichen Mantelflächen 104-107 gleichmäßig und ganzflächig aufgebracht ist. Das dielektrische Schichtsystem ist mit einem geeigneten Verfahren auf der Oberfläche der Mantelflächen 104-107 aufgebracht, z.B. aufgedampft, und besteht in einer beispielhaften, jedoch nicht limitierenden Ausführungsform aus einer Abfolge von Lanthanfluorid (LaF₃) / Chiolith -Schichten gemäß Tabelle 1a:

**Tabelle 1a:**

| Schicht-Nr. | Physikalische Dicke [nm] | Material |
|---|---|---|
| Luft | | |
| 1 | 68.3 | LaF₃ |
| 2 | 25.3 | Chiolith |
| 3 | 72.8 | LaF₃ |
| 4 | 33.3 | Chiolith |
| 5 | 46.5 | LaF₃ |
| 6 | 38.4 | Chiolith |
| 7 | 23.0 | LaF₃ |
| Substrat | | CaF₂ |

Die optischen Konstanten bei einer Arbeitswellenlänge von ca. 193nm ergeben sich aus Tabelle 1b, wobei die Werte in Abhängigkeit von den Beschichtungsparametern den üblichen Schwankungen unterliegen. Hierbei geben n bzw. k den Real- bzw. den Imaginärteil des komplexen Brechungsindex an. Die Brechzahl n von Kalziumfluorid (CaF₂), aus dem gemäß dem Ausführungsbeispiel der Integratorstab gebildet ist, beträgt bei der Arbeitswellenlänge von ca. 193nm etwa n≈ 1.51.

**Tabelle 1b:**

| Material | n | K |
|---|---|---|
| LaF₃ | 1.67 | 0.0002 |
| Chiolith | 1.36 | 0.0004 |

Somit weist das dielektrische Schichtsystem gemäß der ersten Ausführungsform ein erstes dielektrisches Material (LaF₃) mit einer Brechzahl n₁ größer als die Brechzahl n des Materials des Integratorstabs (CaF₂) und ein zweites dielektrisches Material (Chiolith) mit einer Brechzahl n₂ kleiner als die Brechzahl n des Materials des Integratorstabs auf. Ein weiteres Ausführungsbeispiel eines geeigneten dielektrischen Schichtsystems besteht aus einer Abfolge von Lanthanfluorid (LaF₃) / Magnesiumfluorid (MgF₂)-Schichten, wie gemäß Tabelle 2a definiert.

**Tabelle 2a:**

| Schicht-Nr. | Physikalische Dicke [nm] | Material |
|---|---|---|
| Luft | | |
| 1 | 61.4 | LaF₃ |
| 2 | 53.5 | MgF₂ |
| 3 | 57.5 | LaF₃ |
| 4 | 40.7 | MgF₂ |
| 5 | 43.0 | LaF₃ |
| 6 | 56.6 | MgF₂ |
| 7 | 20.0 | LaF₃ |
| Substrat | | CaF₂ |

Die optischen Konstanten bei einer Arbeitswellenlänge von ca. 193nm ergeben sich aus Tabelle 2b.

**Tabelle 2b:**

| Material | N | k |
|---|---|---|
| LaF₃ | 1.67 | 0.0002 |
| MgF₂ | 1.44 | 0.0002 |

Ein weiteres Ausführungsbeispiel eines geeigneten dielektrischen Schichtsystems besteht aus einer Abfolge von Neodymfluorid (NdF₃) / Chiolith-Schichten, wie gemäß Tabelle 3a definiert.

**Tabelle 3a:**

| Schicht-Nr. | Physikalische Dicke [nm] | Material |
|---|---|---|
| Luft | | |
| 1 | 48.6 | NdF₃ |
| 2 | 48.7 | Chiolith |
| 3 | 22.4 | NdF₃ |
| Substrat | | CaF₂ |

Die optischen Konstanten bei einer Arbeitswellenlänge von ca. 193nm ergeben sich aus Tabelle 3b.

**Tabelle 3b:**

| Material | n | K |
|---|---|---|
| NdF₃ | 1.73 | 0.0005 |
| Chiolith | 1.36 | 0.0004 |

Die Erfindung ist nicht auf die obigen konkreten Zusammensetzungen des dielektrischen Schichtsystems beschränkt. Vorzugsweise umfasst das dielektrischen Schichtsystem jedoch wenigstens zwei unterschiedliche dielektrische Materialien, von denen das eine Material eine Brechzahl n₁ aufweist, welche größer als die Brechzahl n des Materials des Integratorstabs ist, und das zweite dielektrische Material eine zweite Brechzahl n₂ aufweist, welche kleiner als die Brechzahl n des Materials des Integratorstabs ist.

Insbesondere kann beispielsweise das erste dielektrische Material (mit einer Brechzahl n₁ größer als die Brechzahl n des Materials des Integratorstabs) aus der Gruppe ausgewählt sein, welche aus Lanthanfluorid (LaF₃), Neodymfluorid (NdF₃), Aluminiumoxid (Al₂O₃), Gadoliniumfluorid (GdF₃), Dysprosiumfluorid (DyF₃), Erbiumfluorid (ErF₃) und Zirkoniumfluorid (ZrF₄) besteht. Das zweite dielektrische Material (mit einer Brechzahl n₂ kleiner als die Brechzahl n des Materials des Integratorstabs) kann insbesondere aus der Gruppe ausgewählt sein, welche aus Chiolith, Magnesiumfluorid (MgF₂), Lithiumfluorid (LiF), Natriumfluorid (NaF), Siliziumdioxid (SiO₂), Kryolith und Aluminiumfluorid (AlF₃) besteht.

Nachfolgend wird beispielhaft davon ausgegangen, dass das auf den Mantelflächen 104-107 des Integratorstabs 101 angeordnete Schichtsystem 108 so ausgestaltet ist, dass für einen im Bereich der mit dem Schichtsystem 108 belegten Mantelfläche reflektierten Lichtstrahl gerade eine Phasenaufspaltung (Phasensprung) von 180° zwischen der senkrecht zur Einfallsebene orientierten Komponente Eₛ des elektrischen Feldvektors und der parallel zur Einfallsebene orientierten Komponente Eₚ des elektrischen Feldvektors erfolgt.

Unter Bezugnahme auf Fig. 1 wird beispielsweise davon ausgegangen, dass in die Lichteintrittsfläche 102 des Integratorstabs 101 eintretendes Licht parallel zur y-Richtung linear polarisiert ist (wobei die z-Richtung in Längsrichtung des Integratorstabs 101, und die x-Richtung in die Papierebene zeigt). Der eintretende Lichtstrahl 110 wird nach Durchlaufen einer Teilstrecke 110a an der oberen Mantelfläche 104 totalreflektiert (wobei diese Totalreflexion in Fig. 1 mit "T1" bezeichnet ist), nach Durchlaufen einer Teilstrecke 110b an der unteren Mantelfläche 105 totalreflektiert (mit "T2" bezeichnet), nach Durchlaufen einer Teilstrecke 110c an der oberen Mantelfläche 104 totalreflektiert (mit "T3" bezeichnet), und nach Durchlaufen einer Teilstrecke 110d an der unteren Mantelfläche 105 totalreflektiert (mit "T4" bezeichnet), und tritt nach Durchlaufen einer Teilstrecke 110e an der Lichtaustrittsfläche 103 des Integratorstabs 101 aus. Die Anzahl der in Fig. 1 angedeuteten Totalreflexionen ist selbstverständlich nur beispielhaft, wobei typischerweise eine wesentlich größere Anzahl von Totalreflexionen an den Mantelflächen 104-107 auftritt.

Nimmt man beispielsweise an, dass vor der Totalreflexion "T2" die parallel zur Einfallsebene orientierte Komponente Eₚ in der Phase der senkrecht zur Einfallsebene orientierten Komponente Eₛ vorauseilt, so eilt (infolge des bei der Totalreflexion stattfindenden Phasensprunges von etwa 180°) nach der Totalreflexion "T2" die parallel zur Einfallsebene orientierte Komponente Eₚ in der Phase der senkrecht zur Einfallsebene orientierten Komponente Eₛ hinterher, und zwar um die gleiche Phasendifferenz, um die sie vor der Totalreflexion vorausgeeilt ist. Bei der nächsten Totalreflexion "T3" findet erneut ein Phasensprung von 180° zwischen der senkrecht zur Einfallsebene orientierten Komponente Eₛ des elektrischen Feldvektors und der parallel zur Einfallsebene orientierten Komponente Eₚ des elektrischen Feldvektors statt, so dass nach der Totalreflexion "T3" die parallel zur Einfallsebene orientierte Komponente Eₚ in der Phase wieder der senkrecht zur Einfallsebene orientierten Komponente Eₛ vorauseilt etc..

Gemäß Fig. 2 weist ein schematisch in Seitenansicht dargestellter erfindungsgemäßer Lichtintegrator 200 in einem weiteren Ausführungsbeispiel einen Integratorstab 201 von beispielsweise quaderförmiger Geometrie mit einer Lichteintrittsfläche 202, einer Lichtaustrittsfläche 203 sowie vier Mantelflächen 204-207 auf, von denen in Fig. 2 nur die obere Mantelfläche 204, die untere Mantelfläche 205 und die vordere Mantelfläche 206 erkennbar sind.

Bei dem Lichtintegrator 200 sind die Mantelflächen 204-207 jeweils mit einem optischen Retarder 208 belegt, welcher aus einem geeigneten doppelbrechenden Material mit geeigneter Schichtdicke so hergestellt ist, dass er eine Lambda/4-Platte ausbildet, die gemäß dem Ausführungsbeispiel auf sämtlichen Mantelflächen 204-207 gleichmäßig und ganzflächig mittels eines geeigneten Verfahrens aufgebracht (z.B. angesprengt) ist. Die Lambda/4-Platte kann aus einem geeigneten doppelbrechenden Material, beispielsweise für eine Arbeitswellenlänge von 193nm aus Magnesiumfluorid (MgF₂) oder Quarz (SiO₂) hergestellt sein. Die Orientierung der schnellen (gemäß einer alternativen Ausführungsform der langsamen Kristallachse) ist in Fig. 2 mittels des Hilfsstrichs 209 bezeichnet.

In der Ausführungsform gemäß Fig. 2 hat die auf der Mantelfläche befindliche Lambda/4-Platte zur Folge, dass zwischen zwei aufeinanderfolgenden Totalreflexionen an Mantelflächen, die mit der Lambda/4-Platte belegt sind, ein durch den Integratorstab hindurchlaufender Lichtstrahl zweimal die Dicke der Lambda/4-Platte durchläuft, insgesamt also zwischen zwei aufeinanderfolgenden Totalreflexionen gleichsam eine Lambda/2-Platte durchquert.

Die im Lichtweg zwischen zwei Totalreflexionen jeweils doppelt durchlaufene Lambda/4-Platte bewirkt nach dem zweifachen Durchlauf eines Lichtstrahls eine Lambda/2-Phasenaufspaltung dieses Lichtstrahls, also eine 180°-Phasenaufspaltung zwischen der senkrecht zur Einfallsebene orientierten Komponente Eₛ des elektrischen Feldvektors und der parallel zur Einfallsebene orientierten Komponente Eₚ des elektrischen Feldvektors.

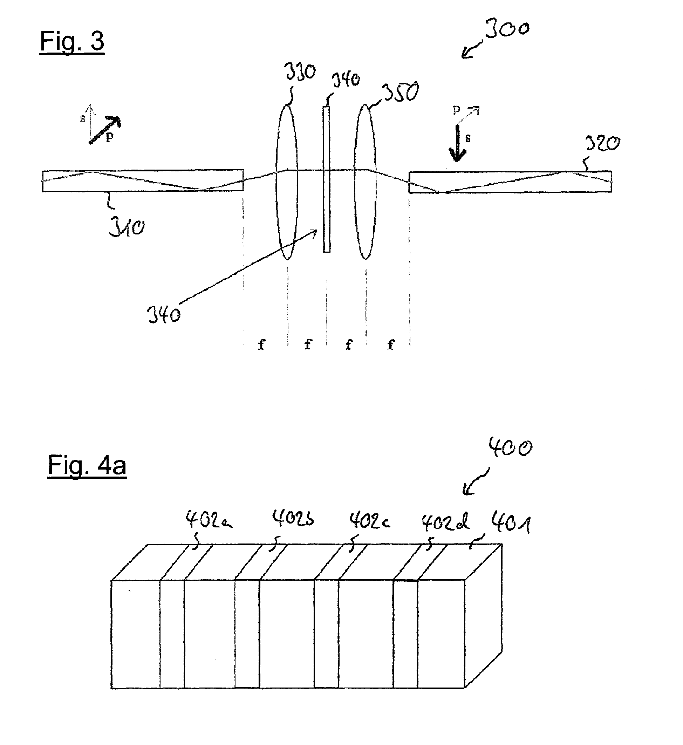

Gemäß Fig. 3 weist ein schematisch in Seitenansicht dargestellter erfindungsgemäßer Lichtintegrator 300 in einem weiteren Ausführungsbeispiel zusätzlich zu einem ersten Integratorstab 310 einen zweiten Integratorstab 320 auf, wobei der zweite Integratorstab 320 eine im Wesentlichen identische Belegung seiner Mantelflächen wie der erste Integratorstab 310 sowie im Wesentlichen identische Abmessungen aufweist. Die Integratorstäbe 310, 320 können beispielsweise den in Fig. 1 oder auch den in Fig. 2 dargestellten Aufbau aufweisen, so dass auf deren detaillierte Beschreibung hier verzichtet wird, wobei auch sämtliche weitere geeignete, erfindungsgemäße Ausgestaltungen der Integratorstäbe 310, 320 in Betracht kommen. Ferner ist ein Lambda/2-Retarder 340 derart angeordnet, dass durch den Lichtintegrator 300 hindurchtretendes Licht nacheinander den ersten Integratorstab 310, den Lambda/2-Retarder 340 und den zweiten Integratorstab 320 durchquert.

Gemäß Fig. 3 sind ferner im Strahlengang positive Linsen 330 und 350 vorgesehen, wobei die Linse 330 zwischen der Lichtaustrittsfläche des ersten Integratorstabs 310 und dem Lambda/2-Retarder 340, und die Linse 350 zwischen dem Lambda/2-Retarder 340 und der Lichteintrittsfläche des zweiten Integratorstabs 320 angeordnet ist. Die Linsen 330 und 350 können selbstverständlich auch als Linsensysteme aus mehreren Linsen ausgestaltet sein. Linse 330 stellt eine möglichst senkrechte Inzidenz der durch den Lichtintegrator 310 hindurchgetretenen Lichtstrahlen bei Auftreffen auf den Lambda/2-Retarder 340 her, wozu die Lichtaustrittsfläche des ersten Integratorstabs 310 im Abstand der Brennweite f von der Linse 330 angeordnet ist. Linse 350 koppelt durch den Lichtintegrator 300 hindurchtretende Lichtstrahlen in den zweiten Integratorstab 320 ein, dessen Lichteintrittsfläche im Abstand der Brennweite f von der Linse 350 angeordnet ist.

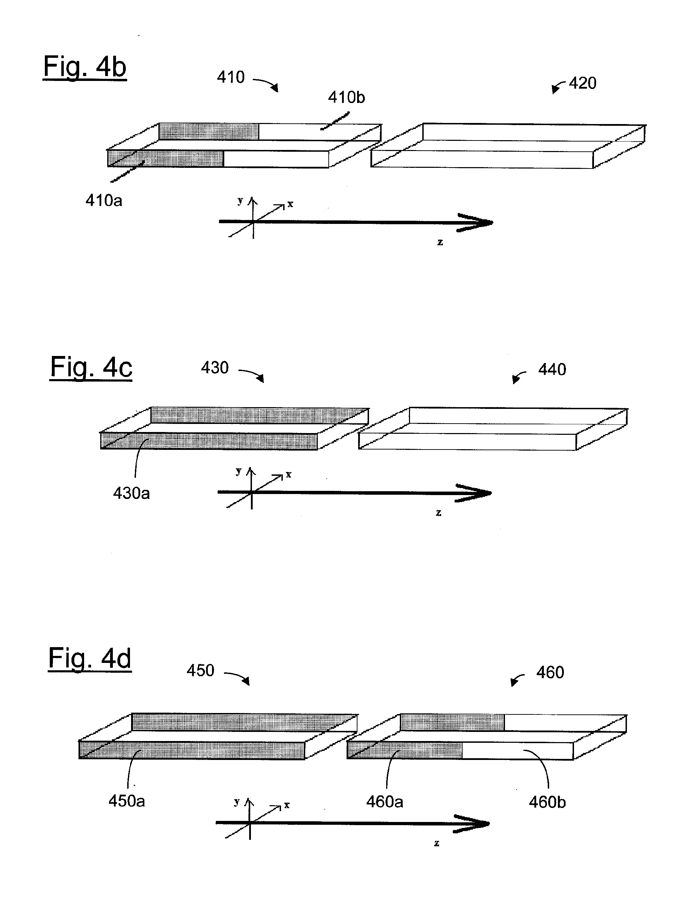

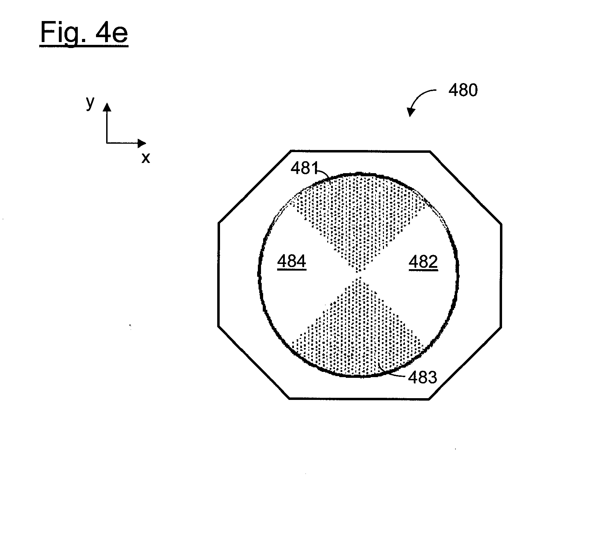

Die Erfindung ist nicht auf die gleichmäßige und ganzflächige Bedeckung der Mantelflächen des Integratorstabs bzw. der Integratorstäbe beschränkt. So kann die Belegung der jeweiligen Mantelfläche mit dem dielektrischen Schichtsystem oder dem optischen Retarder beispielsweise auch nur an zwei einander gegenüberliegend angeordneten Mantelflächen des Integratorstabs vorgesehen sein. Ferner kann die Belegung der jeweiligen Mantelfläche mit dem dielektrischen Schichtsystem oder dem optischen Retarder beispielsweise auch nur bereichsweise vorgesehen sein, wie lediglich beispielhaft und nicht limitierend anhand der in Fig. 4 gezeigten Ausführungsbeispiele erläutert wird.

Der in Fig. 4a gezeigte Lichtintegrator 400 weist einen Integratorstab 401 auf, dessen Mantelflächen nur in entlang der Längsrichtung in im Wesentlichen gleichen Abständen angeordneten, vorzugsweise streifenförmigen Bereichen 402a-402d mit einem dielektrischen Schichtsystem belegt sind. Analog zu Fig. 2 können die streifenförmigen Bereiche 402a-402d auch mit einer Lambda/4-Platte belegt sein.

Im Unterschied zu der Ausführungsform gemäß Fig. 1 tritt hier eine 180°-Phasenaufspaltung zwischen der senkrecht zur Einfallsebene orientierten Komponente Eₛ des elektrischen Feldvektors und der parallel zur Einfallsebene orientierten Komponente Eₚ des elektrischen Feldvektors nicht bei jeder Totalreflexion, sondern lediglich jeweils nach einer Mehrzahl von Totalreflexionen statt. Die lediglich bereichsweise Belegung der Mantelflächen hat den Vorteil, dass eine in den belegten Bereichen der Mantelflächen erfolgende Abnahme der Reflektivität reduziert wird. Da eine Abnahme der Reflektivität wiederum eine verstärkte Elliptizität infolge unterschiedlicher Anzahl von Totalreflexionen in x- bzw. y-Richtung zur Folge haben kann, wird bei (beispielsweise gemäß Fig. 4a) nur bereichsweise belegten Mantelflächen somit einer unerwünschten Zunahme der Elliptizität entgegengewirkt. Diese "Elliptizität" ist bezogen auf die sich nach Lichtaustritt aus dem Stab ergebende Intensitätsverteilung und resultiert daraus, dass die durch den jeweiligen Stab hindurchtretenden Strahlen an den breiten Mantelflächen häufiger als an den schmalen Mantelflächen reflektiert werden, so dass sich in Verbindung mit der absorbierenden Wirkung der dielektrischen Schichten unterschiedliche Abschwächungen der Strahlen ergeben und sich demzufolge die Intensität in der horizontalen Richtung von der Intensität in der vertikalen Richtung unterscheidet. Der Wert E(H,V) der Elliptizität bezeichnet dabei definitionsgemäß für zwei Paare von jeweils punktsymmetrisch zur optischen Achse in vertikaler Richtung bzw. horizontaler Richtung einander gegenüberliegenden Quadranten in der Pupille das Verhältnis der Summe der Intensitäten in den in vertikaler Richtung einander gegenüberliegenden Quadranten zu der Summe der Intensitäten in den in horizontaler Richtung einander gegenüberliegenden Quadranten. Ein Wert E(H,V)=1 bezeichnet demnach eine gleichmäßige Intensitätsverteilung in der Pupille.

Selbstverständlich ist die Erfindung im Falle einer nur bereichsweise erfolgenden Belegung der Mantelflächen mit einem dielektrischen Schichtsystem oder einem optischen Retarder (Lambda/4-Platte) nicht hinsichtlich Zahl oder Geometrie der belegten Bereiche beschränkt, sondern diese können in beliebiger geeigneter Anzahl und Form (ggf. abgestimmt auf Lichtquelle bzw. das verwendete Beleuchtungssetting), sowohl auf allen Mantelflächen als auch nur auf zwei gegenüberliegenden Mantelflächen vorgesehen sein.

In Fig. 4b-d sind weitere Ausführungsbeispiele dargestellt, bei denen jeweils der Lichtintegrator ebenfalls zwei Teilstäbe umfasst, wobei sämtliche dieser Ausführungsbeispiele sich durch eine nur bereichsweise Belegung der Mantelflächen mit einem dielektrischen Schichtsystem auszeichnen. Dabei kann zwischen den beiden Teilstäben optional auch wie bereits beschrieben ein Lambda/2-Retarder angeordnet sein, es können jedoch die beiden Teilstäbe von Fig. 4b-d auch aus fertigungstechnischen Gründen (und ohne Lambda/2-Retarder) vorgesehen sein. Eine nur bereichsweise Belegung der Mantelflächen mit einem dielektrischen Schichtsystem kann gemäß weiterer (nicht dargestellter) Ausführungsformen auch bei einem Lichtintegrator mit nur einem Stab (analog zu Fig. 1) erfolgen, der dann beispielsweise entsprechend dem jeweils ersten Stab in den in Fig. 4b-d gezeigten Konfigurationen belegt sein kann (und z.B. zur Erzielung der gleichen Homogenisierungswirkung die doppelte Länge wie einer der Stäbe der in Fig. 4b-d gezeigten Konfigurationen aufweisen kann).

In den lediglich schematischen Darstellungen vom Fig. 4b-d sind die unbelegten Mantelflächen weiß gekennzeichnet, und die belegten Mantelflächen (Bereiche 410a in Fig. 4b, 430a in Fig. 4b und 450a und 460a in Fig. 4d) sind jeweils grau gekennzeichnet. Die Teilstäbe 410, 420, 430, 440, 450 und 460 weisen jeweils eine quaderförmige Geometrie auf, wobei das Aspektverhältnis des rechteckigen Stabquerschnitts senkrecht zur entlang der z-Richtung verlaufenden Lichtausbreitungsrichtung (definiert als das Verhältnis von Höhe bzw. kleinerer Seitenlänge zu Breite bzw. größerer Seitenlänge) ebenso wie in den vorangegangenen Ausführungsbeispielen beispielsweise im Bereich von 1:1 bis 1:8 liegen kann.

Fig. 4b und 4c zeigen Konfigurationen, bei denen jeweils nur die schmalen Mantelflächen des in Bezug auf die Lichtausbreitungsrichtung ersten Stabes 430 bzw. 450 mit einer dielektrischen Schicht belegt sind, wobei diese Belegung gemäß Fig. 4c vollständig und gemäß Fig. 4b hälftig (im entlang der Lichtausbreitungsrichtung zunächst durchlaufenen Bereich 430a des ersten Stabes 430) erfolgt. Bei der in Fig. 4d gezeigten Konfiguration erfolgt zusätzlich zu einer vollständigen Belegung der schmalen Mantelflächen 450a des ersten Stabes 450 noch eine hälftige Belegung des zweiten Stabes 460 (ebenfalls im entlang der Lichtausbreitungsrichtung zunächst durchlaufenen Bereich 460a des zweiten Stabes 460). Die Erfindung ist auch hinsichtlich der nur bereichsweise erfolgenden Belegung nicht auf die gezeigten Konfigurationen beschränkt, so dass die jeweils belegten Bereiche in Größe und Anordnung variieren können.

Gemäß einer weiteren, nicht dargestellten Ausführungsform kann auch die durch die Belegung der schmalen Mantelflächen gemäß Fig. 4b-d eingeführte Elliptizität der Intensitätsverteilung durch eine zusätzliche Belegung der breiten Mantelflächen kompensiert werden. In diesem Falle entspricht vorzugsweise das Belegungsverhältnis, welches als das Verhältnis der belegten Oberfläche der schmalen Mantelflächen zur belegten Oberfläche der breiten Mantelfläche des jeweiligen Stabes definiert ist, dem Aspektverhältnis dieses Integratorstabes (d.h. dem Verhältnis von Höhe bzw. kleinerer Seitenlänge zu Breite bzw. größerer Seitenlänge). Das Belegungsverhältnis kann ferner auch geringfügig (z.B. um wenige Prozent) größer als das Aspektverhältnis gewählt werden, um auch eine ggf. von unbelegten Oberflächen eingeführte Elliptizität in der Intensitätsverteilung zu kompensieren.

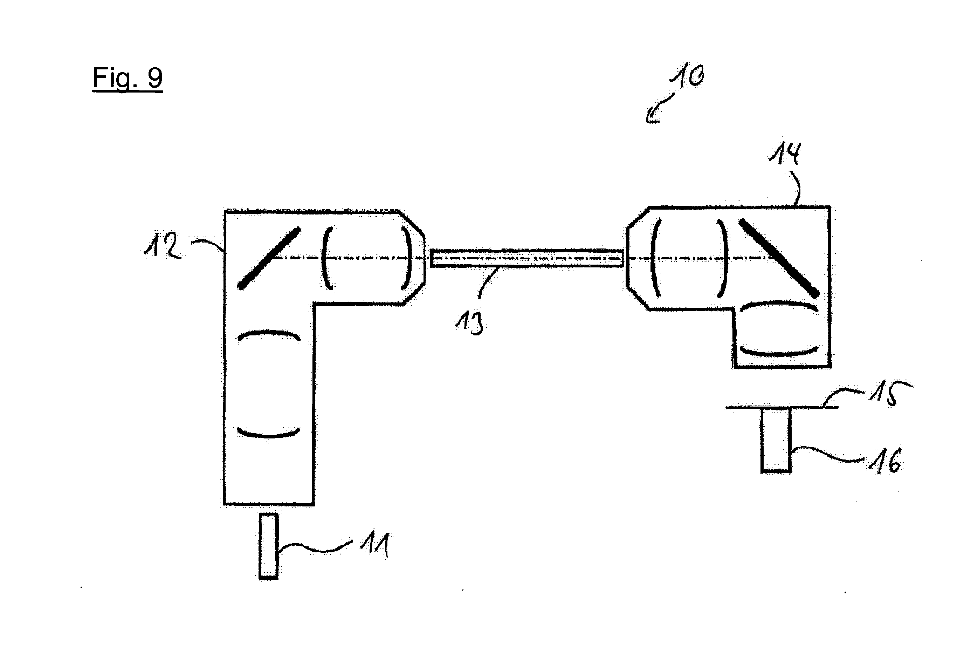

Gemäß einer bevorzugten Ausgestaltung erfolgt ferner erfindungsgemäß in Verbindung mit der oben beschriebenen, partiellen Belegung der Stabmantelflächen der Einsatz eines geeigneten Elliptizitätsfilters in Form eines Transmissionsfilters mit einer zweizähligen Symmetrie, wie es grundsätzlich z.B. aus WO 2005/006079 A1 bekannt ist. Ein solches Transmissionsfilter kann beispielsweise gemäß Fig. 4e in Form eines scheibenförmigen Filterelementes 480 ausgebildet sein, auf dem mehrere Flächen mit unterschiedlichen Transmissionsgraden segmentartig angeordnet sind. Das Transmissionsfilter 480 ist z.B. in vier punktsymmetrisch zur Mittelachse angeordnete Quadranten 481-484 unterteilt, von denen jeweils zwei sich bezüglich der Mittelachse bzw. der optischen Systemachse gegenüberliegende Quadranten ein Paar mit jeweils gleichem Transmissionsgrad bilden und von denen z.B. das eine Paar 482, 484 einen Transmissionsgrad von annähernd 100% und das andere Paar 481, 483 einen geringeren Transmissionsgrad (von z.B. 90%) aufweisen kann. Das Elliptizitätsfilter kann in einem Beleuchtungssystem, dessen Aufbau weiter unten anhand von Fig. 9 näher erläutert wird, z.B. in einer Pupillenebene des REMA-Objektivs angeordnet sein und dient dann dazu, die durch die (partielle) dielektrische Belegung der Mantelflächen eingeführte Elliptizität der Intensitätsverteilung wenigstens teilweise zu korrigieren.

Tabelle 4 gibt für die Konfigurationen von Fig. 4b-d die jeweils berechneten, zu erwartenden Werte für die relative IPS-Zunahme, die Elliptizität und die relative Transmission (im Vergleich zu einer Konfiguration ohne Belegung der Mantelflächen) an, wobei die Reflektivität der mit dielektrischer Schicht belegten Mantelflächen zu 98% und die Reflektivität unbelegten Mantelflächen zu 99.8% angenommen wurde. Dabei bezeichnet der "IPS-Wert" den Grad der Verwirklichung eines gewünschten Polarisationszustandes an einem bestimmten Ort (IPS = "**I**ntensity in **P**referred **S**tate"), d.h. der IPS-Wert gibt das energetische Verhältnis der Lichtintensität in einer Sollrichtung (die z.B. mit einem idealen Polarisator, dessen Durchlassrichtung in die Sollrichtung eingestellt ist, gemessen werden kann) zur Gesamtintensität an. Die relative IPS-Zunahme bezeichnet die relative Verstärkung des IPS-Wertes im Vergleich zu der analogen Konfiguration ohne Belegung der Mantelflächen. Die Elliptizität ist in Tabelle 4 als Elliptizitätsoffset, d.h. betragsmäßige Abweichung von dem (einer gleichmäßigen Intensitätsverteilung in der Pupille entsprechenden) Wert E(H,V)=1 angegeben (d.h. bei einer Elliptizität von 1.08 beträgt der Elliptizitätsoffset |1-E(H,V)|=0.08 = 8%.

**Tabelle 4:**

| Konfiguration | Relative IPS--Zunahme [%] | Elliptizitätsoffset \|1-E(H,V)\| [%] | Relative Transmission [%] |
|---|---|---|---|
| Fig. 4b | 1 | < 1 | > 98 |
| Fig. 4c | 3.2 | < 4 | > 96 |
| Fig. 4d | 6.6 | < 8 | > 94 |

Wie aus Tabelle 4 ersichtlich, führt eine ausgeprägtere Belegung der Mantelflächen zwar zu einem größeren Polarisationserhalt (d.h. einem größerem Wert der relativen IPS-Zunahme), jedoch auch zu einem größeren Intensitätsverlust, so dass je nach Anwendungsfall auch ein geeigneter Kompromiss eingestellt werden kann, um einen geringeren, aber noch ausreichenden Polarisationserhalt bei dafür nicht zu großem Intensitätsverlust zu erreichen.

Gemäß einer weiteren Ausführungsform kann eine im Integratorstab z.B. durch die Belegung der schmalen Mantelflächen gemäß Fig. 4b-d eingeführte Elliptizität der Intensitätsverteilung auch durch einen anderenorts im Beleuchtungssystem eingeführten Beitrag zur Elliptizität der Intensitätsverteilung kompensiert werden. Ein solcher Beitrag resultiert beispielsweise aus auf den Linsen des Beleuchtungssystem vorhandenen, antireflektierenden Schichten oder Schichtsystemen (AR-Schichten) sowie auf Spiegeln vorhandenen hochreflektierenden Schichten oder Schichtsystemen (HR-Schichten), wobei es sich gezeigt hat, dass z.B. AR-Schichten bei Verwendung eines Beleuchtungssettings (z.B. C-Quad-Setting) mit linear polarisiertem Licht von einheitlicher linearer Polarisationsvorzugsrichtung einen Elliptizitätsoffset der Intensitätsverteilung von mehr als 5% bewirken können. Dieser Effekt kann nun erfindungsgemäß ausgenutzt werden, indem die Belegung der Stabmantelflächen gezielt gerade so gewählt wird, dass sich der Elliptizitätsbeitrag aufgrund dieser Belegung der Mantelflächen und der weitere Elliptizitätsbeitrag aufgrund der vorhandenen AR-Schichten und/oder HR-Schichten einander wenigstens teilweise oder sogar (nahezu) vollständig kompensieren, wobei dann auf einen zusätzlichen Elliptizitätsfilter, wie er oben im Zusammenhang mit Fig. 4e beschrieben wurde, verzichtet wird.

Gemäß einem (nicht dargestellten) Ausführungsbeispiel zur Ausnutzung dieses Kompensationseffektes kann unter Bezugnahme auf Fig. 4b-d etwa in x-Richtung (senkrecht zu Scanrichtung) linear polarisiertes Licht in das Beleuchtungssystem eingestrahlt werden. Die Gesamtheit der AR-Schichten und HR-Schichten auf den im Beleuchtungssystem vorhandenen Linsen bzw. Spiegeln erzeugt einen Elliptizitätswert E(HV) < 1. Dies ist auf die polarisationsabhängige Transmission an besagten Schichten zurückzuführen, die darauf beruht, dass s-polarisiertes Licht jeweils besser reflektiert p-polarisiertes Licht. Geht man jeweils von einem auf die jeweilige Linse einfallenden Lichtbüschel mit einer kreisförmigen Lichtverteilung mit homogener Polarisation in x-Richtung aus, so wird das in x-Richtung polarisierte Licht auf den pupillennahen Linsen in den in vertikaler Richtung einander gegenüberliegenden Quadranten der Pupille (y-Segmente) als s-polarisiertes Licht schlechter transmittiert, als es in den in horizontaler Richtung einander gegenüberliegenden Quadranten (x-Segmente) als p-polarisiertes Licht (bezüglich der Einfallsebenen auf die Linsen) transmittiert wird. Die dielektrische Belegung der schmalen Stabmantelflächen erzeugt einen hierzu inversen Effekt auf den E(HV)-Wert, da das Licht infolge der jeweiligen Belegung der schmalen Mantelflächen in den x-Segmenten der Pupille stärker abgeschwächt wird als in den y-Segmenten.

Nachfolgend wird anhand von Simulationsergebnissen bzw. Berechnungen die mittels erfindungsgemäßer Lichtintegratoren erzielbare Auswirkung insbesondere auf den Polarisationserhalt anhand von Beispielen erläutert.

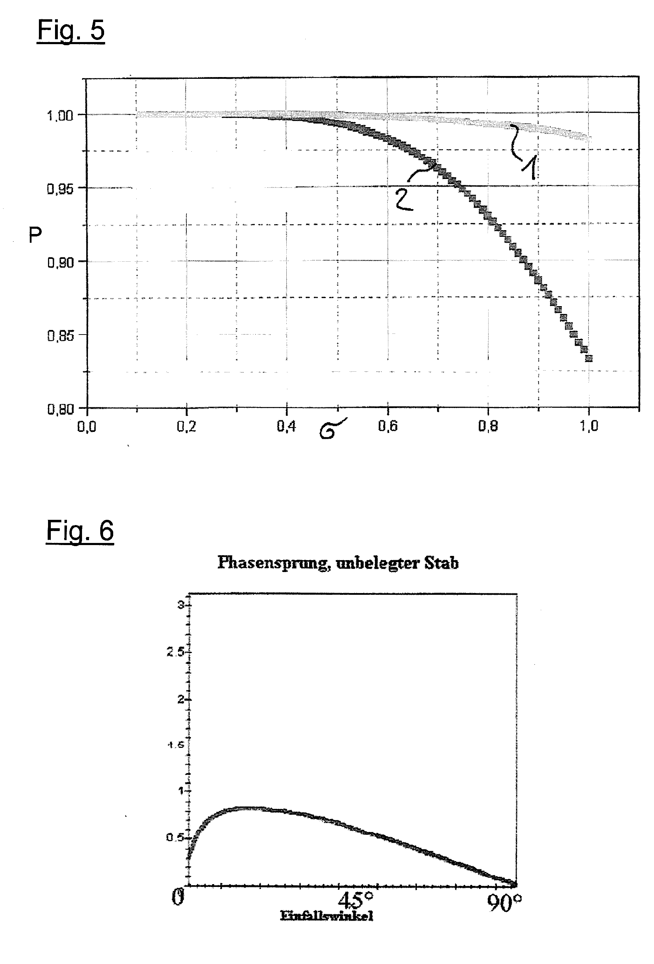

Fig. 5 zeigt eine mittels Simulation berechnete Abhängigkeit des gemittelten linearen Polarisationsgrads P am Stabaustritt von dem Parameter σ, welcher die auf die maximale Systemapertur normierte numerische Apertur am Stabeintritt angibt. Hierbei wurde wie oben davon ausgegangen, dass das Licht am Stabeintritt zu 100 % in y-Richtung linear polarisiert ist, also am Stabeintritt einen linearen Polarisationsgrad von Eins aufweist. Die Simulation wurde für Stababmessungen von 38.4*3.9*600 mm² und eine Brechzahl n=1.559 (Kalziumfluorid bei 157nm) durchgeführt, und zwar sowohl für einen unbelegten Integratorstab (Kurve "2") als auch für einen belegten Integratorstab (Kurve "1"). Hier wurde für den belegten Integratorstab bei jeder im Bereich der Belegung erfolgenden Totalreflexion ein idealer Phasensprung von 180° zwischen der senkrecht zur Einfallsebene orientierten Komponente Eₛ des elektrischen Feldvektors und der parallel zur Einfallsebene orientierten Komponente Ep des elektrischen Feldvektors zugrundegelegt.

Vergleicht man in Fig. 5 etwa die Werte des linearen Polarisationsgrads P bei σ=1 (was gleichbedeutend damit ist, dass die numerische Apertur am Stabeintritt gleich der maximalen Systemapertur von NA=0.9 ist), so zeigt sich dass der lineare Polarisationsgrads P am Stabaustritt infolge der Belegung der Mantelflächen von P < 85% für den unbelegten Integratorstab auf P > 98% für den belegten Integratorstab ansteigt.

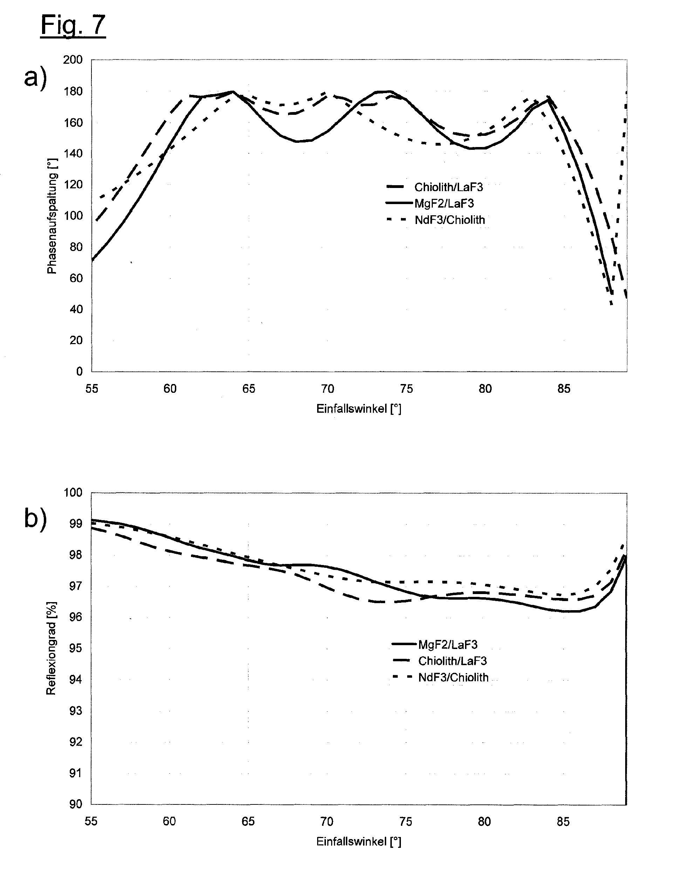

Gemäß Fig. 7 sind für die in den obigen Tabellen 1-3 definierten dielektrischen Schichtsystemen die Phasenaufspaltung (Fig. 7a) zwischen der senkrecht zur Einfallsebene orientierten Komponente Eₛ und der parallel zur Einfallsebene orientierten Komponente Eₚ sowie der Reflexionsgrad (Fig. 7b) in Abhängigkeit vom Einfallswinkel dargestellt, wobei die Werte durch Simulationen ermittelt wurden. Zum Vergleich ist in Fig. 6 die Abhängigkeit des bei Totalreflexion an den Mantelflächen auftretenden Phasensprunges vom Einfallswinkel für einen Lichtintegrator mit Mantelflächen ohne erfindungsgemäße Belegung gezeigt.

Wie aus Fig. 7a ersichtlich, lassen sich für sämtliche dieser Designbeispiele von dielektrischen Schichtsystemen, im Einfallswinkelbereich von etwa 60° bis 85°, Werte der Phasenaufspaltung zwischen der senkrecht zur Einfallsebene orientierten Komponente Eₛ des elektrischen Feldvektors und der parallel zur Einfallsebene orientierten Komponente Ep des elektrischen Feldvektors von über 140° erreichen, wobei die Werte zum Teil den idealen Wert von 180° erreichen oder nur um wenige Grad darunter liegen. Wie aus Fig. 7b ersichtlich, liegt der Reflexionsgrad dieser Designbeispiele von dielektrischen Schichtsystemen, im Einfallswinkelbereich von etwa 60° bis 85°, oberhalb von 96%.

Gemäß einer weiteren Ausführungsform kann die erfindungsgemäße Belegung von Mantelflächen des Stabintegrators auch mit der Zielsetzung erfolgen, die bei den jeweiligen Totalreflexionen an den Mantelflächen stattfindenden Phasensprünge zwischen der senkrecht zur Einfallsebene orientierten Komponente Eₛ des elektrischen Feldvektors und der parallel zur Einfallsebene orientierten Komponente Eₚ des elektrischen Feldvektors zu minimieren.

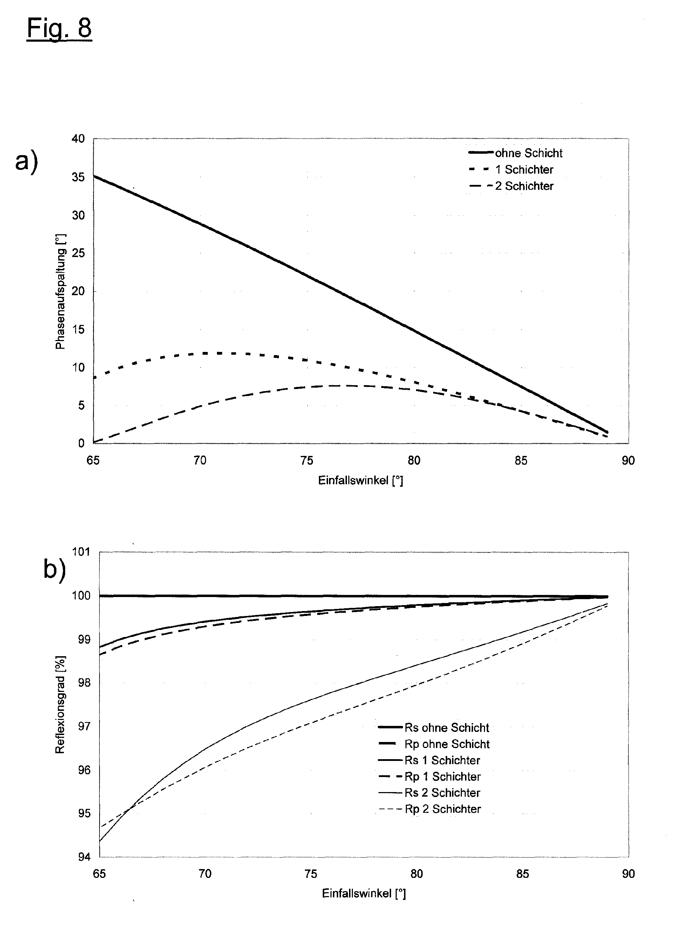

In Fig. 8 ist eine mittels Simulation berechnete Abhängigkeit der Phasenaufspaltung (Fig. 8a) bzw. des Reflexionsgrades (Fig. 8b) von dem Einfallswinkel für einen derartigen Lichtintegrator mit einem Integratorstab aus CaF₂ ohne bzw. mit Belegung mit erfindungsgemäßer Schichtstruktur im Einfallswinkelbereich von 65° bis 90° dargestellt.

Wie aus Fig. 8a ersichtlich ist, wird im Vergleich zu einem Integratorstab ohne Belegung seiner Mantelflächen (Kurve "ohne Schicht") für einen Integratorstab mit belegter Mantelfläche der vom Einfallswinkel abhängige Phasensprung zwischen der senkrecht zur Einfallsebene orientierten Komponente Eₛ des elektrischen Feldvektors und der parallel zur Einfallsebene orientierten Komponente Eₚ des elektrischen Feldvektors bei einer Totalreflexion signifikant verringert, wobei eine Kurve ("1-Schichter") für eine Einfachschicht aus Chiolith mit ca. 172 nm Dicke, und eine weitere Kurve ("2-Schichter") für ein Zweifach-Schichtsystem mit einer Chiolith-Schicht von ca. 141 nm Dicke und einer Al₂O₃-Schicht von ca. 78 nm Dicke ermittelt wurde. Gemäß Fig. 8a ist im Falle des Zweifach-Schichtsystems zwar die Verringerung des Phasensprunges noch deutlich ausgeprägter als im Falle der Einfachschicht, dieser Effekt ist jedoch gemäß Fig. 8b auch verbunden mit einer Abnahme des Reflexionsgrades und damit einer Steigerung der Elliptizität in der energetischen Lichtverteilung der Pupille (aufgrund der unterschiedlichen Anzahl von Totalreflexionen in x- bzw. y-Richtung in einem Integratorstab mit rechteckigem Aspektverhältnis), was sich allerdings durch Pupillenfilter im Wesentlichen korrigieren lässt.

Fig. 9 zeigt eine schematische Darstellung des Aufbaus eines Beleuchtungssystems einer mikrolithographischen Projektionsbelichtungsanlage mit einem Lichtintegrator gemäß der vorliegenden Erfindung.

Gemäß Fig. 9 weist ein Beleuchtungssystem 10 eine Lichtquelle 11 (beispielsweise ein ArF-Laser für eine Arbeitswellenlänge von 193 nm oder ein F₂-Laser für eine Arbeitswellenlänge von 157 nm), eine Kollektoreinheit 12, einen Lichtintegrator 13 und ein REMA-Objektiv 14 auf. Die Kollektoreinheit 12 fokussiert von der Lichtquelle 11 kommendes Licht auf den Lichtintegrator 13. Der Lichtintegrator weist einen Aufbau auf, wie er oben anhand beispielhafter Ausführungsformen beschrieben wurde. Die Lichtaustrittsfläche des Lichtintegrators 13 wird mittels des REMA-Objektivs 14 in die Retikelebene 15 abgebildet, in welcher die Maske (= Retikel) angeordnet ist und in der beispielsweise mittels einer Polarisations-Messeinrichtung 16 der Polarisationsgrad an unterschiedlichen Feldpunkten gemessen werden kann.

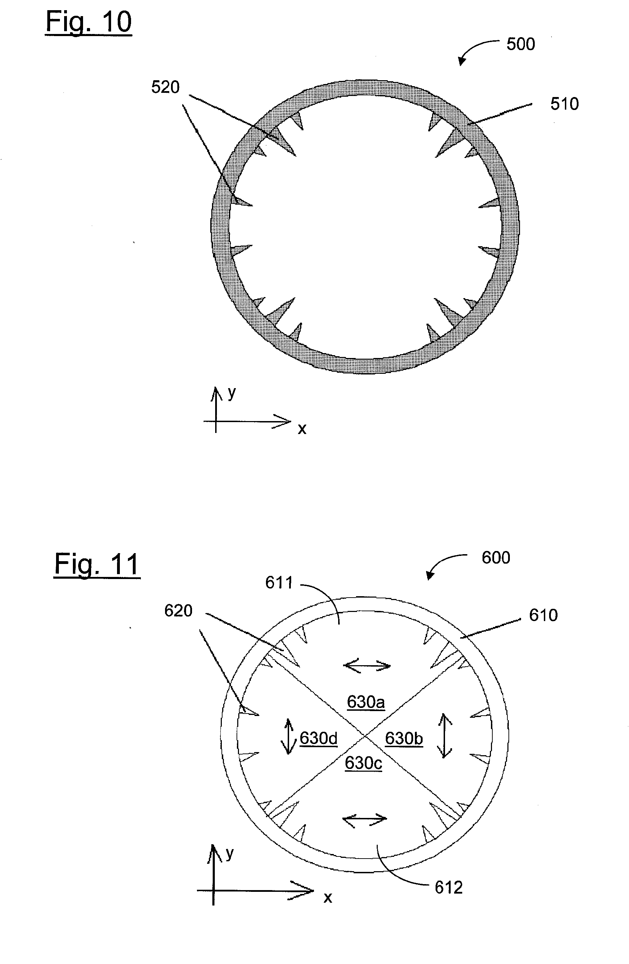

Da je nach Geometrie des Integratorstabes bzw. der Integratorstäbe des erfindungsgemäßen Lichtintegrators 13 die Güte der Polarisationserhaltung über die Pupillenebene des REMA-Objektivs 14 variieren kann, erfolgt gemäß einer bevorzugten Ausgestaltung der Erfindung zur Verbesserung des mittleren Polarisationserhaltes der Einsatz einer speziellen Blende, welche die vergleichsweise schlechter polarisierten Bereiche ausfiltert und deren Ausgestaltung durch die Geometrie des Integratorstabes vorgegeben ist. Eine solche geeignete Ausgestaltung einer Blende ist in Fig. 10 gezeigt. Diese Blende 500 weist an einem äußeren Ring 510 eine Mehrzahl von radial nach innen ragenden, lichtblockierenden Vorsprüngen 520 auf, die eine im Wesentlichen zackenförmige Geometrie ("spikes") aufweisen, wobei sie sich in radialer Richtung von außen nach innen hin verjüngen bzw. spitz zulaufen, wobei der Öffnungswinkel dieser zackenförmigen Vorsprünge 520 typischerweise im Bereich von etwa 1-5° liegen kann. Die Position dieser nach innen ragenden Vorsprünge 520 über den Umfang des Ringes 510 ist so gewählt, dass die Vorsprünge 520 das Licht an den Pupillenorten, an denen die Polarisation durch die Stabgeometrie maximal gestört wird, ausfiltern, so dass dieses Licht nicht zu dem mittleren Polarisationserhalt beiträgt, so dass der mittlere Polarisationserhalt verbessert wird. Die Positionen und Abmessungen der radialen Vorsprünge 520 sind durch Geometrie des Lichtintegrators 13 (Aspektverhältnis und Länge) vorgegeben. Zur geeigneten Auslegung der Blende 500 kann beispielsweise mittels der Polarisations-Messeinrichtung 16 der Polarisationsgrad an unterschiedlichen Feldpunkten in der Retikelebene 15 gemessen werden, um zu bestimmen, wo für den konkreten verwendeten Lichtintegrator 13 die Bereiche mit relativ schlechter Polarisationserhaltung (schlechtem IPS-Wert) liegen, um diese dann mit der entsprechend hergestellten Blende 500 auszufiltern. Typische radiale Abmessungen der Vorsprünge 520 liegen etwa in Bereich von 1/10 bis 1/5 des Gesamtradius des Ringes 510. Dieser Gesamtradius kann je nach Einsatzort in der Beleuchtungseinrichtung geeignet gewählt werden und liegt im Falle des bevorzugten Einsatzes in der Pupillenebene des REMA-Objektivs 14 bei etwa 100 mm. Die Blende 500 in der in Fig. 10 gezeigten Ausführung ist geeignet für eine Konfiguration, in welcher über den Azimutalwinkel die entlang der positiven und negativen x- bzw. y-Richtung liegenden Positionen einen relativ guten Polarisationserhalt aufweisen, jedoch hingegen Positionen, die in Bezug auf die positive y-Achse azimutal um einen Winkel von 45° oder ein ganzzahliges Vielfaches hiervon versetzt sind, einen relativ schlechteren Polarisationserhalt aufweisen.

Die Blende kann gemäß einer weiteren Ausgestaltung auch bezogen auf die Lichtausbreitungsrichtung vor dem Lichtintegrator 13 angeordnet sein, beispielsweise in einer Pupillenebene der Kollektoreinheit 12. In diesem Falle ist der Radius des Ringes 510 entsprechend anzupassen und liegt typischerweise in der Größenordnung von etwa 50 mm.

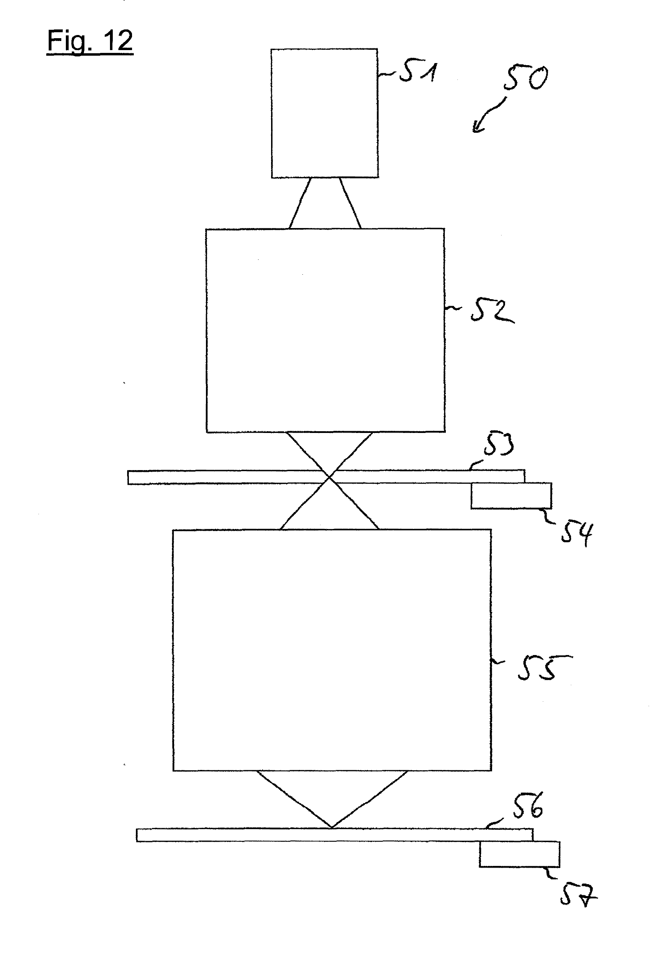

Eine weitere Ausgestaltung einer Blende zur Verbesserung des mittleren Polarisationserhaltes ist in Fig. 11 dargestellt. Diese Blende 600 weist ebenfalls einen mit radial nach innen vorstehenden Vorsprüngen 620 versehenen Ring 610 auf und unterscheidet sich von der Blende 500 von Fig. 11 dadurch, dass in von dem Ring umgebenen Bereichen 630a, 630c zwei einander gegenüberliegend angeordnete, planparallele Plattenelemente 611, 612 angeordnet sind, welche jeweils eine Drehung der Polarisationsrichtung von linear polarisiertem Licht um 90° oder ein ungeradzahliges Vielfaches hiervon bewirken. Diese Plattenelemente 611, 612 können beispielsweise aus optisch aktivem Material in Form von kristallinem Quarz ausgebildet sein, wobei die optische Kristallachse parallel zur in Lichtausbreitungsrichtung verlaufenden z-Achse orientiert ist. Gemäß einer alternativen Ausgestaltung können diese Plattenelemente 611, 612 auch in Form von Lambda/2-Platten (etwa aus MgF₂ oder einem anderen geeigneten, hinreichend transparenten Material) ausgestaltet sein. Bei der Blende von Fig. 11 erfolgt somit für eintretendes, in y-Richtung linear polarisiertes Licht in den Bereichen 630a und 630c eine Drehung der Polarisationsvorzugsrichtung um 90° (oder ein ungeradzahliges Vielfaches hiervon). In den übrigen Bereichen 630b und 630d, die gemäß dem Beispiel von Fig. 11 nicht mit Material ausgefüllt sind, erfolgt keine Änderung der Polarisationsvorzugsrichtung. Insgesamt bewirkt die Blende 600 somit zusätzlich zu der oben beschriebenen Ausfilterung unerwünschter Bereiche mit relativ schlechterem Polarisationserhalt auch die Erzeugung einer "quasi-tangentialen" Polarisationsverteilung, wie durch die die nach der Blende 600 jeweils erzeugte Polarisationsvorzugsrichtung kennzeichnenden Doppelpfeilen angedeutet ist. Selbstverständlich können in den Bereichen 630b und 630d zum gleichen Zweck auch planparallele Plattenelemente aus optisch aktivem Material in Form von kristallinem Quarz angeordnet sein, wobei die optische Kristallachse in diesen Plattenelementen parallel zur in Lichtausbreitungsrichtung verlaufenden z-Achse orientiert ist, und wobei die Dicke so gewählt ist, dass sich für eintretendes, in y-Richtung linear polarisiertes Licht in den Bereichen 630b und 630d eine Drehung der Polarisationsvorzugsrichtung um 180° (oder ein geradzahliges Vielfaches hiervon) ergibt.

Fig. 12 zeigt eine schematische Darstellung des Aufbaus einer mikrolithographischen Projektionsbelichtungsanlage mit einem Beleuchtungssystem gemäß der vorliegenden Erfindung.

Gemäß Fig. 12 weist eine mikrolithographische Projektionsbelichtungsanlage 50 eine Lichtquelle 51, ein Beleuchtungssystem 52, eine Maske (Retikel) 53, eine Maskenträgereinheit 54, ein Projektionsobjektiv 55, ein lichtempfindliche Strukturen aufweisendes Substrat 56 und eine Substratträgereinheit 57 auf. Das Beleuchtungssystem 52 ist gemäß Fig. 9 ausgebildet und weist einen erfindungsgemäßen Lichtintegrator auf.

Das Bild der mittels des Beleuchtungssystems 52 beleuchteten Maske 13 wird hierbei mittels des Projektionsobjektivs 55 auf das mit einer lichtempfindlichen Schicht (Photoresist) beschichtete und in der Bildebene des Projektionsobjektivs 55 angeordnete Substrat 56 (z.B. einen Siliziumwafer) projiziert, um die Maskenstruktur auf die lichtempfindliche Beschichtung des Substrats 56 zu übertragen.

Zusammenfassend wird mit dem erfindungsgemäßen Lichtintegrator ein besserer Polarisationserhalt in einem Beleuchtungssystem insbesondere einer mikrolithographischen Projektionsbelichtungsanlage ermöglicht.

Wenn die Erfindung auch anhand spezieller Ausführungsformen beschrieben wurde, erschließen sich für den Fachmann zahlreiche Variationen und alternative Ausführungsformen, z.B. durch Kombination und/oder Austausch von Merkmalen einzelner Ausführungsformen. Dementsprechend versteht es sich für den Fachmann, dass derartige Variationen und alternative Ausführungsformen von der vorliegenden Erfindung mit umfasst sind, und die Reichweite der Erfindung nur im Sinne der beigefügten Patentansprüche und deren Äquivalente beschränkt ist.

## Patentansprüche

1. Lichtintegrator (100, 200, 300, 400) für ein Beleuchtungssystem, insbesondere für eine mikrolithographische Projektionsbelichtungsanlage, mit
• wenigstens einem Integratorstab (101, 201, 310, 320, 401, 410, 420, 430, 440, 450, 460) aus einem für Licht einer Lichtquelle transparenten Material, welcher eine Lichteintrittsfläche (102, 202), eine Lichtaustrittsfläche (103, 203), und Mantelflächen (104-107, 204-207) aufweist;
• wobei wenigstens eine der Mantelflächen (104-107, 204-207) zumindest bereichsweise mit einer Belegung präpariert ist, welche derart ausgestaltet ist, dass sie für in die Lichteintrittsfläche (102, 202) eintretendes, linear polarisiertes Licht einer bei einem Integratorstab ohne diese Belegung erfolgenden Änderung des Polarisationszustandes zwischen dem Lichteintritt in die Lichteintrittsfläche (102, 202) und dem Lichtaustritt aus der Lichtaustrittsfläche (103, 203) entgegenwirkt.

2. Lichtintegrator nach Anspruch 1, **dadurch gekennzeichnet, dass** die Belegung derart ausgestaltet ist, dass für in die Lichteintrittsfläche (102, 202) eintretendes, linear polarisiertes Licht der Polarisationszustand beim Austritt aus der Lichtaustrittsfläche (103, 203) im Wesentlichen erhalten bleibt.

3. Lichtintegrator nach Anspruch 1 oder 2, **dadurch gekennzeichnet, dass** die Belegung (108, 402a-402d) in Form einer dielektrischen Schichtstruktur ausgebildet ist.

4. Lichtintegrator nach Anspruch 3, **dadurch gekennzeichnet, dass** die dielektrische Schichtstruktur für einen im Bereich der Schichtstruktur reflektierten Lichtstrahl in einem vorgegebenen Einfallswinkelbereich einen Phasensprung zwischen zwei zueinander senkrechten Polarisationszuständen im Bereich von 130° bis 230°, bevorzugt im Bereich von 155° bis 205°, und noch bevorzugter von etwa 180° bewirkt.

5. Lichtintegrator nach Anspruch 3, **dadurch gekennzeichnet, dass** die dielektrische Schichtstruktur so ausgebildet ist, dass für einen im Bereich der Schichtstruktur reflektierten Lichtstrahl in einem vorgegebenen Einfallswinkelbereich ein Phasensprung zwischen zwei zueinander senkrechten Polarisationszuständen geringer als 30°, bevorzugt geringer als 20° und noch bevorzugter geringer als 10° ist.

6. Lichtintegrator nach einem der vorhergehenden Ansprüche, **dadurch gekennzeichnet, dass** die Schichtstruktur wenigstens eine erste Schicht aus einem ersten dielektrischen Material und wenigstens eine zweite Schicht aus einem zweiten dielektrischen Material aufweist, wobei das erste dielektrische Material eine erste Brechzahl n aufweist, welche größer als die Brechzahl des Materials des Integratorstabs ist, und das zweite dielektrische Material eine zweite Brechzahl n aufweist, welche kleiner als die Brechzahl des Materials des Integratorstabs ist.

7. Lichtintegrator nach Anspruch 6, **dadurch gekennzeichnet, dass** das erste dielektrische Material aus der Gruppe ausgewählt ist, welche aus Lanthanfluorid (LaF₃), Neodymfluorid (NdF₃), Aluminiumoxid (Al₂O₃), Gadoliniumfluorid (GdF₃), Dysprosiumfluorid (DyF₃), Erbiumfluorid (ErF₃) und Zirkoniumfluorid (ZrF₄) besteht.

8. Lichtintegrator nach Anspruch 6 oder 7, **dadurch gekennzeichnet, dass** das zweite dielektrische Material aus der Gruppe ausgewählt ist, welche aus Chiolith, Magnesiumfluorid (MgF₂), Lithiumfluorid (LiF), Natriumfluorid (NaF), Siliziumdioxid (SiO₂), Kryolith und Aluminiumfluorid (AlF₃) besteht.

9. Lichtintegrator nach Anspruch 1 oder 2, **dadurch gekennzeichnet, dass** die Belegung in Form einer auf der jeweiligen Mantelfläche wenigstens bereichsweise angeordneten Lambda/4-Platte (208) ausgebildet ist.

10. Lichtintegrator nach einem der vorhergehenden Ansprüche, **dadurch gekennzeichnet, dass** zusätzlich zu dem ersten Integratorstab (310, 410, 430, 450) ein zweiter Integratorstab (320, 420, 440, 460) vorgesehen ist.

11. Lichtintegrator nach Anspruch 10, **dadurch gekennzeichnet, dass** ferner ein Lambda/2-Retarder (340) derart vorgesehen ist, dass durch den Lichtintegrator (300) hindurchtretendes Licht nacheinander den ersten Integratorstab (310), den Lambda/2-Retarder (340) und den zweiten Integratorstab (320) durchquert.

12. Lichtintegrator nach Anspruch 10 oder 11, **dadurch gekennzeichnet, dass** die Belegung nur an dem ersten Integratorstab vorgesehen ist.

13. Lichtintegrator nach einem der vorhergehenden Ansprüche, **dadurch gekennzeichnet, dass** die Belegung nur an zwei einander gegenüberliegend angeordneten Mantelflächen des betreffenden Integratorstabs (101, 201, 310, 320) vorgesehen ist.

14. Lichtintegrator nach einem der vorhergehenden Ansprüche, **dadurch gekennzeichnet, dass** der jeweilige Integratorstab mit einem senkrecht zur Lichtausbreitungsrichtung rechteckigen Querschnitt mit zwei breiteren und zwei schmaleren Mantelflächen ausgebildet ist, wobei nur die schmaleren Mantelflächen vollständig oder teilweise mit der Belegung präpariert sind.

15. Lichtintegrator nach einem der vorhergehenden Ansprüche, **dadurch gekennzeichnet, dass** die Belegung zumindest an zwei einander gegenüberliegend angeordneten Mantelflächen des Integratorstabs (401) nur in entlang der Längsrichtung in im Wesentlichen gleichen Abständen angeordneten, vorzugsweise streifenförmigen Bereichen ausgebildet ist.

16. Lichtintegrator nach einem der vorhergehenden Ansprüche, **dadurch gekennzeichnet, dass** er für eine Arbeitswellenlänge von 248 nm, bevorzugt 193 nm, noch bevorzugter 157 nm ausgelegt ist.

17. Mikrolithographische Projektionsbelichtungsanlage (50), welche ein Beleuchtungssystem (10, 52) und ein Projektionsobjektiv (55) aufweist, wobei das Beleuchtungssystem (10, 52) einen Lichtintegrator nach einem der vorhergehenden Ansprüche aufweist.

18. Mikrolithographische Projektionsbelichtungsanlage nach Anspruch 17, **dadurch gekennzeichnet, dass** das Beleuchtungssystem ein Elliptizitätsfilter aufweist, welches einen durch die Belegung der Mantelflächen eingeführten elliptischen Anteil in der sich nach Stabaustritt ergebenden Intensitätsverteilung reduziert.

19. Mikrolithographische Projektionsbelichtungsanlage nach Anspruch 17, **dadurch gekennzeichnet, dass** die Belegung der Mantelflächen so gewählt ist, dass sich ein durch die Belegung der Mantelflächen eingeführter erster Elliptizitätsbeitrag in der sich in einer Retikelebene der Beleuchtungseinrichtung ergebenden Intensitätsverteilung und ein durch im Beleuchtungssystem vorhandene antireflektierende und/oder hochreflektierende Schichten eingeführter zweiter Elliptizitätsbeitrag in der sich in der Retikelebene ergebenden Intensitätsverteilung einander wenigstens teilweise kompensieren.

20. Mikrolithographische Projektionsbelichtungsanlage nach einem der Ansprüche 17 bis 19, **dadurch gekennzeichnet, dass** das Beleuchtungssystem eine Blende (500, 600) aufweist, welche einen äußeren Ring (510, 610) sowie eine Mehrzahl an von diesem äußeren Ring (510, 610) radial nach innen ragenden, lichtblockierenden Vorsprüngen (520, 620) aufweist, welche derart angeordnet sind, dass durch selektives Herausfiltern von Bereichen des Lichtbündelquerschnitts der mittlere Polarisationserhaltungsgrad gegenüber einem Beleuchtungssystem ohne die Blende verbessert wird.

21. Verfahren zur mikrolithographischen Herstellung mikrostrukturierter Bauelemente mit folgenden Schritten:
• Bereitstellen eines Substrats (56), auf das zumindest bereichsweise eine Schicht aus einem lichtempfindlichen Material aufgebracht ist;
• Bereitstellen einer Maske (53), die abzubildende Strukturen aufweist;
• Bereitstellen einer Projektionsbelichtungsanlage (50) nach einem der Ansprüche 17 bis 20;
• Projizieren wenigstens eines Teils der Maske (53) auf einen Bereich der Schicht mit Hilfe der Projektionsbelichtungsanlage (50).

22. Mikrostrukturiertes Bauelement, das nach einem Verfahren nach Anspruch 21 hergestellt ist.
